Europäisches Patentamt

European Patent Office

Office européen des brevets

(11) Veröffentlichungsnummer: **0 576 805 A1**

# EUROPÄISCHE PATENTANMELDUNG

(21) Anmeldenummer: **93107336.5**

(51) Int. Cl.5: **G01R 31/36**

(22) Anmeldetag: **06.05.93**

(30) Priorität: **03.07.92 DE 4221894**

(43) Veröffentlichungstag der Anmeldung:
**05.01.94 Patentblatt 94/01**

(84) Benannte Vertragsstaaten:
**AT BE CH DE DK ES FR GB GR IE IT LI NL PT SE**

(71) Anmelder: **THEO BENNING ELEKTROTECHNIK UND ELEKTRONIK GMBH & CO. KG**
**Münsterstrasse 135 - 137**
**D-46397 Bocholt(DE)**

(72) Erfinder: **Buschfort, Friedhelm**
**Auf dem Brink 16a**
**W-4290 Bocholt(DE)**
Erfinder: **Saul, Wilhelm**
**Up'm Höwel 27**
**W-4290 Bocholt(DE)**

(74) Vertreter: **Stenger, Watzke & Ring**
**Patentanwälte**
**Kaiser-Friedrich-Ring 70**
**D-40547 Düsseldorf (DE)**

(54) **Verfahren zur Ermittlung des aktuellen Ladezustandes einer Traktionsbatterie eines Flurförderfahrzeuges.**

(57) Bei einem Verfahren zur Ermittlung des aktuellen Ladezustandes einer Traktionsbatterie eines Flurförderfahrzeuges wird, ausgehend von der meßtechnisch erfaßten aktuellen Batteriespannung und einer vorgegebenen, Batteriespannung und Restkapazität in Beziehung zueinander setzenden Bezugslinie, eine Differenzspannung (dU) ermittelt. Aus der Kenntnis der Differenzspannung (dU) wird dann der Ladezustand der Traktionsbatterie, d.h. deren Restkapazität, errechnet. Um auch bei sich ändernden Lastfällen ohne eine Erfassung der jeweiligen Batteriebelastung auszukommen und um Instabilitäten und Sprünge der ermittelten Restkapazitätswerte zu vermeiden, wird aus der Differenzspannung (dU) zwischen der zyklisch gemessenen Batteriespannung ($U_{akt}$) und dem Referenz-Spannungswert der Bezugslinie die aktuelle Batteriebelastung zunächst durch Abschätzung ermittelt. Hieraus wird dann der Wert (d%) der jeweiligen Kapazitätsabnahme errechnet.

Fig. 4

Die Erfindung betrifft ein Verfahren zur Ermittlung des aktuellen Ladezustandes einer Traktionsbatterie eines Flurförderfahrzeuges, bei dem ausgehend von der meßtechnisch erfaßten aktuellen Batteriespannung und einer vorgegebenen, Batteriespannung und Restkapazität in Beziehung zueinander setzenden Bezugslinie eine Differenzspannung ermittelt und hieraus der Ladezustand der Traktionsbatterie errechnet wird.

Aus der Patentschrift DD 294 107 A5 ist ein Verfahren zur Ermittlung des aktuellen Ladezustandes einer Traktionsbatterie bekannt, bei dem zur Ermittlung der Restkapazität auch bei wechselnder Belastung zunächst eine Bezugslinie als Meßbezugswert geschaffen wird. Im Lastfall, d.h. bei Lastaufschaltung der Batterie wird von dieser Bezugslinie eine ermittelte Differenzspannung abgezogen, wobei sich entsprechend dem Differenzwert eine neue aktuelle Last-Bezugslinie ergibt. Diese Last-Bezugslinie wird also gewissermaßen durch Verschieben aus der festen, batteriespezifischen Bezugslinie gewonnen. Zur Ermittlung der Differenzspannung wird die aktuelle Batteriespannung fortlaufend gemessen. Weicht sie weniger als um ein vorgegebenes Maß von der Bezugslinie ab, so wird ein konstanter Lastfall angenommen und dieser Kurve gefolgt. Bei einer größeren Differenzspannung wird ein geänderter Lastfall angenommen und die Last-Bezugslinie entsprechend verschoben, so daß bei diesem bekannten Verfahren insgesamt eine Schar von Lastkennlinien abgefahren werden kann. Dem Verfahren liegen digitale Eingangssignale über die Art der Belastung vor, etwa bei Verwendung der Batterie zum Betrieb eines Flurförderfahrzeuges. Diese Signale werden für eine Quasi-Strommessung genutzt und dienen damit der Abschätzung der Batteriebelastung.

Der Erfindung liegt die **Aufgabe** zugrunde, ein Verfahren zur Ermittlung des aktuellen Ladezustandes einer Traktionsbatterie für Flurförderfahrzeuge zu schaffen, das auch bei sich ändernden Lastfällen ohne eine Erfassung der jeweiligen Batteriebelastung auskommt und frei von Instabilitäten und Sprüngen der ermittelten Restkapazitätswerte arbeitet.

Zur **Lösung** der Aufgabe wird bei einem Verfahren der eingangs genannten Art vorgeschlagen, daß aus der Differenzspannung zwischen der zyklisch gemessenen Batteriespannung und dem Referenz-Spannungswert der Bezugslinie die aktuelle Batteriebelastung durch Abschätzung ermittelt und hieraus der Wert der jeweiligen Kapazitätsabnahme errechnet wird.

Ein solches Verfahren bietet den Vorteil, auch bei sich ändernden Lastfällen ohne eine Erfassung der jeweiligen Batteriebelastung auszukommen. Das Verfahren arbeitet zudem selbststabilisierend, d.h. eine Fehleinschätzung der Restkapazität wird selbsttätig ausgeglichen. Die Änderungsgeschwindigkeit der ermittelten Restkapazitätswerte wird begrenzt, so daß es einerseits nicht zum Springen des beispielsweise auf einer Digitalanzeige angezeigten Ergebnisses innerhalb zweier Meßwertausgaben kommen kann, und andererseits die Dynamik bei einer Fehleinschätzung, wie sie etwa beim Anklemmen einer nicht voll geladenen Batterie entstehen kann, ebenso begrenzt ist. Das erfindungsgemäße Verfahren bietet also auch den Vorteil, frei von Instabilitäten und Sprüngen der ermittelten Restkapazitätswerte zu arbeiten.

Mit einer Weiterbildung des Verfahrens wird vorgeschlagen, daß der Wert der jeweils errechneten Kapazitätsabnahme von dem zuletzt ermittelten Restkapazitätswert subtrahiert und der auf diese Weise neu errechnete Restkapazitätswert in einem Datenspeicher abgelegt wird.

Schließlich wird mit der Erfindung vorgeschlagen, daß für die einzelnen Lastfälle die Abhängigkeit zwischen der Differenzspannung und dem Wert der jeweiligen Kapazitätsabnahme in Form einer Funktion d% = f(dU) abgespeichert ist.

Weitere Einzelheiten und Vorteile des Gegenstandes der Erfindung ergeben sich aus der nachfolgenden Beschreibung der zugehörigen Zeichnungen, in denen Ausführungsmöglichkeiten des erfindungsgemäßen Verfahrens dargestellt sind. In den Zeichnungen zeigen:

Fig. 1    in einem Diagramm verschiedene Belastungskurven einer Traktionsbatterie;

Fig. 2    in einem Diagramm eine Funktion d% = f(dU);

Fig. 3    in einem Blockschaltbild den Aufbau sowie die Auswertung der Meßwerte bei dem Verfahren und

Fig. 4    in einem weiteren Diagramm das dem Verfahren zugrundeliegende Meßprinzip.

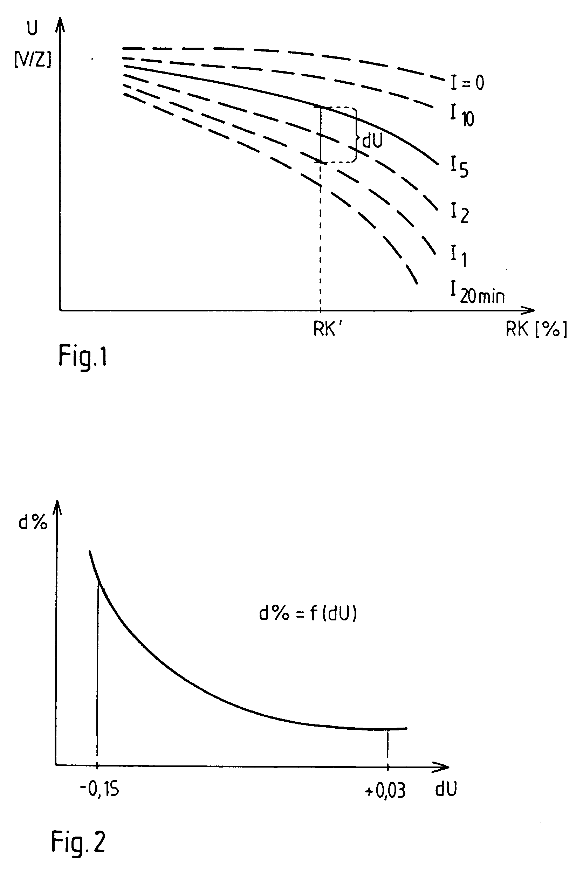

In Fig. 1 sind verschiedene Belastungszustände einer Traktionsbatterie dargestellt. Auf der Abszisse ist jeweils die Restkapazität (RK) in Prozentwerten eingetragen, während die Ordinate die jeweilige Batteriespannung in Volt pro Zelleneinheit wiedergibt. Die einzelnen Lastlinien $I = 0$, $I_{10}$, $I_5$, $I_2$, $I_1$ und $I_{20min}$ geben einzelne mögliche Batteriebelastungen wieder, wie sie bei einem Flurförderfahrzeug etwa durch die Lastfälle "Fahrt vorwärts", "Fahrt rückwärts", "Heben" und "Senken" entstehen können. Hierbei ist davon auszugehen, daß bei einem Flurförderfahrzeug, beispielsweise einem Gabelstapler, die jeweiligen Lastfälle hinsichtlich der damit einhergehenden Batteriebelastungen I bekannt sind. Für die nachfolgenden Erläuterungen wird als Beispiel von einer Referenz-Bezugslinie $I_5$ ausgegangen, also von einer Bezugslinie, die durch die drei Parameter Restkapazität RK, Spannung U und Batteriebelastung $I_5$ festgelegt ist. Diese

Referenz-Bezugslinie ist in Fig. 1 durchgezogen dargestellt und ist gerätespezifisch abgelegt bzw. abgespeichert.

Durch eine zyklische Meßwerterfassung an der Batterie wird die jeweils aktuelle Batteriespannung U erfaßt und durch Subtraktion dieser Batteriespannung von der entsprechenden Referenzspannung eine Differenzspannung dU gebildet. Diese Differenzspannung ist in Fig. 1 für den Restkapazitätswert RK' dargestellt. In Fig. 2 ist dargestellt, daß über eine Funktion d% = f(dU) aus der Differenzspannung ein Wert d% ermittelt wird, der dann der Errechnung der aktualisierten Restkapazität $RK_{akt}$ zugrundegelegt wird.

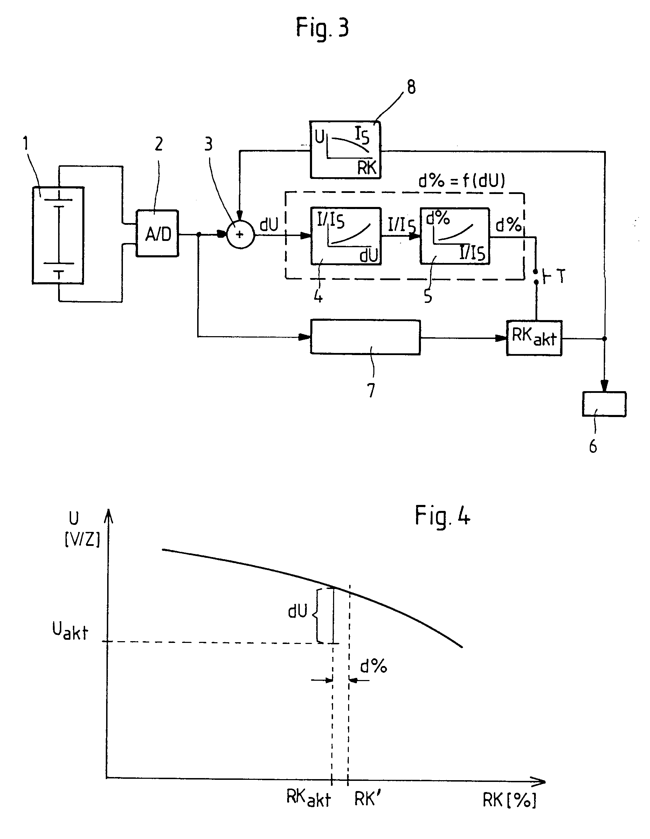

Die Ermittlung des Wertes d% wird nachfolgend anhand des Blockschaltbildes gemäß Fig. 3 erläutert. Die an der Traktionsbatterie 1 anliegende Spannung wird fortlaufend und zyklisch meßtechnisch erfaßt. Das hierbei gebildete Signal wird in einem Analog-Digital-Wandler 2 digitalisiert. In einem Subtraktionsglied 3 wird aus dem vorliegenden Digitalsignal der Meßspannung dann die Differenzspannung dU ermittelt. In einem ersten Funktionsglied 4 erfolgt dann eine Abschätzung der Größe der Batteriebelastung I aus dem zuvor errechneten Wert der Differenzspannung dU. In dem sich daran anschließenden zweiten Funktionsglied 5 wird aus der Batteriebelastung der Wert d% ermittelt, der den abzuziehenden Prozentwert der Restkapazität pro Meßzyklus darstellt. Dieser Prozentwert ist also in der in Fig. 2 dargestellten Weise unmittelbar von der jeweils ermittelten Differenzspannung dU abhängig, wobei die Werte von dU etwa im Bereich von -0,15 Volt/Zelle bei großer Belastung bis +0,03 Volt/Zelle bei geringer Belastung liegen.

Über den ermittelten Prozentwert d% wird dann die aktualisierte Restkapazität $RK_{akt}$ ermittelt und dem Fahrer des Flurförderfahrzeuges über die Anzeige 6 angezeigt. Bei Start des Verfahrens, etwa bei gerade neu aufgeladener Traktionsbatterie 1, muß der Berechnung der Restkapazität zunächst die Anfangskapazität zugrundegelegt werden. Hierzu dient eine Startwert-Bestimmung 7. Aus dem aktuellen Restkapazitätswert $RK_{akt}$ wird mit Hilfe der abgespeicherten Bezugslinien 8, wie sie in Fig. 1 dargestellt sind, die jeweilige Referenz-Spannung errechnet und hieraus zusammen mit der an der Traktionsbatterie 1 abgegriffenen Batteriespannung die Differenzspannung dU errechnet und damit der nächste Zyklus zur Aktualisierung der Restkapazitätswerte eingeleitet.

Das dem Verfahren zugrundeliegende Meßprinzip ergibt sich außerdem aus dem Diagramm nach Fig. 4. Nach Erfassung der aktuellen Batteriespannung $U_{akt}$ wird zunächst die Differenzspannung dU ermittelt und hieraus die aktuelle Batteriebelastung, hier der Lastfall $I_5$, ermittelt. Ausgehend von dem zuletzt abgespeicherten Restkapazitätswert RK' wird dann über die Größe der Differenzspannung dU der neue Prozentwert d% ermittelt und hieraus der aktualisierte Restkapazitätswert $RK_{akt}$ berechnet.

**Patentansprüche**

1.  Verfahren zur Ermittlung des aktuellen Ladezustandes einer Traktionsbatterie eines Flurförderfahrzeuges, bei dem ausgehend von der meßtechnisch erfaßten aktuellen Batteriespannung und einer vorgegebenen, Batteriespannung und Restkapazität in Beziehung zueinander setzenden Bezugslinie eine Differenzspannung ermittelt und hieraus der Ladezustand der Traktionsbatterie errechnet wird,
    **dadurch gekennzeichnet,**
    daß aus der Differenzspannung (dU) zwischen der zyklisch gemessenen Batteriespannung ($U_{akt}$) und dem Referenz-Spannungswert der Bezugslinie die aktuelle Batteriebelastung (I) durch Abschätzung ermittelt und hieraus der Wert (d%) der jeweiligen Kapazitätsabnahme errechnet wird.

2.  Verfahren nach Anspruch 1, dadurch gekennzeichnet, daß der Wert (d%) der jeweils errechneten Kapazitätsabnahme von dem zuletzt ermittelten Restkapazitätswert (RK') subtrahiert und der auf diese Weise neu errechnete Restkapazitätswert ($RK_{akt}$) in einem Datenspeicher abgelegt wird.

3.  Verfahren nach Anspruch 1, dadurch gekennzeichnet, daß für die einzelnen Lastfälle die Abhängigkeit zwischen der Differenzspannung (dU) und dem Wert (d%) der jeweiligen Kapazitätsabnahme in Form einer Funktion d% = f-(dU) abgespeichert ist.

Fig.1

d% = f (dU)

Fig. 2

Fig. 3

Fig. 4

Europäisches
Patentamt

# EUROPÄISCHER RECHERCHENBERICHT

Nummer der Anmeldung

EP 93 10 7336

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | DE-A-3 736 481 (GRÄSSLIN)<br>* Spalte 3, Zeile 48 - Spalte 3, Zeile 52; Anspruch 11 *<br>--- | 1-3 | G01R31/36 |
| A | DE-A-2 003 937 (ZEISS)<br>--- | | |
| A | DE-A-2 511 681 (STANDARD ELEKTRIK LORENZ)<br>----- | | |

RECHERCHIERTE SACHGEBIETE (Int. Cl.5 )

G01R

Der vorliegende Recherchenbericht wurde für alle Patentansprüche erstellt

| Recherchenort | Abschlußdatum der Recherche | Prüfer |
|---|---|---|
| DEN HAAG | 15 OKTOBER 1993 | HOORNAERT W. |

EPO FORM 1503 03.82 (P0403)